# EUROPEAN PATENT APPLICATION

(11) **EP 1 701 390 A2**
(43) Date of publication of application: **13.09.2006**
(21) Application number: 06110297.6
(22) Date of filing: 22.02.2006
(51) Int. Cl.: H01L 39/24

(54) **Precursor for fabricating Nb3Sn superconducting wire, and Nb3Sn superconducting wire, and method for fabricating same**

(30) Priority: 10.03.2005 JP 2005067804
(71) Applicant: Kabushiki Kaisha Kobe Seiko Sho (Kobe Steel, Ltd.), Kobe-shi, Hyogo 651-8585 (JP)
(72) Inventor: Miyatake, Takayuki, Kobe Hyogo 651-2271 (JP); Miyazaki, Takayoshi, Kobe Hyogo 651-2271 (JP); Kato, Hiroyuki, Kobe Hyogo 651-2271 (JP); Zaitsu, Kyoji, Kobe Hyogo 651-8871 (JP)
(74) Representative: TBK-Patent

(57) **Abstract**

A method for fabricating a Nb₃Sn superconducting wire includes the steps of loading or inserting a core material containing at least Sn into a pipe member made of Nb or a Nb alloy, inserting the pipe member into a Cu billet to form a composite member, subjecting the composite member to diameter reduction, and then heat-treating the composite member to form a Nb₃Sn superconducting layer from the inner surface of the pipe member, wherein, in the pipe member made of Nb or the Nb alloy after the diameter reduction, the average crystal grain size is 0.1 to 2 µm, and preferably, the total concentration of oxygen, nitrogen, and carbon is 120 ppm or less.

## Description

### BACKGROUND OF THE INVENTION

### 1. Field of the Invention

The present invention relates to Nb₃Sn superconducting wires and methods useful in fabricating such superconducting wires by a tube process or a powder process. More particularly, the invention relates to a Nb₃Sn superconducting wire useful as a material for superconducting magnets for generating magnetic fields, the superconducting magnets being used in nuclear fusion devices, accelerators, power storage devices, physical properties research, and the like, and a method for fabricating the Nb₃Sn superconducting wire.

### 2. Description of the Related Art

In the field in which superconducting wires are practically used, with respect to superconducting magnets used for high resolution nuclear magnetic resonance (NMR) analyzers, since the resolution improves as the magnitude of the magnetic field generated increases, superconducting magnets recently tend to generate higher magnetic fields.

As the superconducting wire used for superconducting magnets which generate high magnetic fields, Nb₃Sn wires have been put into practical use. In the fabrication of Nb₃Sn superconducting wires, a bronze process is primarily employed. In the bronze process, a plurality of Nb-based cores are embedded in a Cu-Sn-based alloy (bronze) matrix, and wire drawing is performed so that the Nb-based cores are formed into filaments. A plurality of the filaments are bundled-into a wire group, the wire group is embedded in copper for stabilization (stabilizing copper), and wire drawing is performed. The wire group is subjected to heat treatment (diffusion heat treatment) at 600°C to 800°C to form a Nb₃Sn compound phase at the interfaces between the Nb-based filaments and the matrix. However, in this process, since the concentration of Sn solid soluble in bronze is limited (15.8% by mass or less), the resulting Nb₃Sn layer has a small thickness, the crystallinity is degraded, and high magnetic field properties are unsatisfactory.

As the method for fabricating Nb₃Sn superconducting wires, in addition to the bronze process, a tube process and a powder process are also known. In the tube process, a Sn core or a Sn alloy core is disposed in a Nb or Nb alloy tube (pipe member), and the tube is inserted into a Cu pipe (Cu billet) to form a composite member. The composite member is subjected to diameter reduction, and then heat treatment is performed to cause diffusion reaction between Nb and Sn, thereby producing Nb₃Sn. Alternatively, in some cases, a composite member to be used may be prepared by a method in which a Sn core or a Sn alloy core is inserted into a Cu pipe, the Cu pipe is disposed in a Nb or Nb alloy tube, and the tube is inserted into another Cu pipe. For example, refer to United States Patent No. 4,043,028 (Patent Document 1).

On the other hand, as the powder process, for example, Japanese Unexamined Patent Application Publication No. 11-250749 (Patent Document 2) discloses, in the claims, paragraph [0019], etc., a process in which Sn and at least one metal (alloying element) selected from the group consisting of Ti, Zr, Hf, V, and Ta are subjected to melt diffusion reaction to form an alloy or intermetallic compound thereof, and the alloy or the intermetallic compound is pulverized to obtain powder of Sn compound starting material. The powder is loaded into a Nb or Nb-based alloy sheath (pipe member) as a core (powder core 2 which will be described below), and diameter reduction is performed. Then, heat treatment (diffusion heat treatment) is performed.

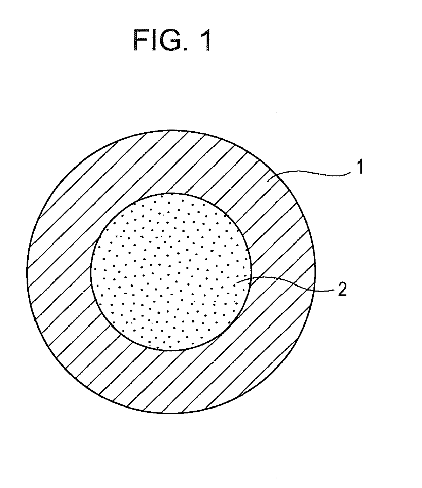

Fig. 1 is a schematic cross-sectional view showing a state in which a Nb₃Sn superconducting wire is fabricated by a powder process. In Fig. 1, reference numeral 1 represents a sheath (pipe member) made of Nb or a Nb-based alloy, and reference numeral 2 represents a powder core which is loaded with starting material powder. When the powder process is carried out, starting material powder containing at least Sn is loaded into the powder core 2 in the sheath 1, and then the sheath 1 is inserted into a Cu billet (not shown) to form a composite member. The composite member is extruded and subjected to diameter reduction, such as wire drawing, to form a wire. Then, the wire is wound in the form of a magnet or the like, and heat treatment is performed to form a Nb₃Sn superconducting phase from the inner surface of the sheath.

Although a single core is shown as a representative example in Fig. 1, practically, it is common to use a multicore member in which a plurality of single cores are disposed in a Cu pipe (Cu billet). This also applies to the tube process.

In the powder process, the heat treatment temperature for forming the superconducting phase is preferably high at about 900°C to 1,000°C. However, it is also known that by adding Cu to starting material powder, the heat treatment temperature can be decreased to about 600°C to 800°C. From such a standpoint, in the powder process, generally, after about 2% to 20% by mass of Cu powder is added to starting material powder, heat treatment for producing an intermetallic compound is performed (refer to Patent Document 2). Furthermore, in the tube process, for such a purpose, a Cu layer (Cu pipe into which the Sn core or Sn alloy core is inserted) may be formed inside a Nb or Nb alloy sheath (refer to Patent Document 1).

In the tube process and the powder process, unlike the bronze process, the Sn concentration is not limited due to the solid solubility limit, and thereby the Sn concentration can be set as high as possible. Furthermore, since a higher quality Nb₃Sn layer with a larger thickness can be formed compared with the bronze process, it is believed that superconducting wires having excellent high magnetic field properties can be obtained. Moreover, diameter reduction can be performed without intermediate annealing, and thus the tube process and the powder process are advantageous in terms of productivity.

### SUMMARY OF THE INVENTION

In the tube process and the powder process, as described above, starting material powder or a Sn alloy core (hereinafter, both being referred to as the "core material") is loaded or inserted into a pipe member made of Nb or a Nb alloy, and the pipe member is further inserted into a Cu billet to form a composite member. The composite member is subjected to extrusion and wire drawing to produce a single core wire, followed by heat treatment. Alternatively, the composite member inserted into the Cu billet is subjected to wire drawing or extrusion and wire drawing to produce a member having a hexagonal cross section. A plurality of the resulting members were bundled and subjected to wire drawing or extrusion and wire drawing to produce a multicore member, followed by heat treatment. However, in these processes, the following problems arise during the processing.

In the tube process and the powder process, the pipe member made of Nb or a Nb alloy is structurally required to have good workability. However, in the pipe members which have been used so far, the change in shape may not occur uniformly during the extrusion and wire drawing process, resulting in the nonuniform thickness of the pipe member in the circumferential direction. As a result, disconnection may occur due to breakage of the pipe member during the processing, or the internal Sn may penetrate the pipe member and diffuse into the Cu matrix (which is hereinafter referred to as "Sn leakage"), thus greatly degrading the superconducting properties.

On the other hand, in the bronze process, since the Nb-based core used is bar-shaped, good workability is not substantially required, and the problems described above do not occur in the usual processing conditions of extrusion and wire drawing. That is, such problems are unique to the powder process or tube process in which the pipe member made of Nb or a Nb alloy is used.

The present invention has been achieved under these circumstances. It is an object of the present invention to provide a method useful in fabricating a Nb₃Sn superconducting wire by a tube process or a powder process, in which uniform working is enabled during extrusion and wire drawing, occurrence of disconnection and Sn leakage can be prevented during the processing, and the resulting Nb₃Sn_{'} superconducting wire can exhibit excellent superconducting properties, and to provide such a Nb₃Sn superconducting wire.

In one aspect of the present invention, a precursor for fabricating a Nb₃Sn superconducting wire includes a composite member including a core material containing at least Sn loaded or inserted into a pipe member made of Nb or an Nb alloy, and a Cu billet being disposed around the pipe member, wherein the pipe member composed of Nb or the Nb alloy has an average crystal grain size of 4 to 80 µm and a total concentration of oxygen, nitrogen, and carbon of 120 ppm or less.

In another aspect of the present invention, a method for fabricating a Nb₃Sn superconducting wire includes the steps of loading or inserting a core material containing at least Sn into a pipe member made of Nb or a Nb alloy, inserting the pipe member into a Cu billet to form a composite member, subjecting the composite member to diameter reduction, and then heat-treating the composite member to form a Nb₃Sn superconducting layer from the inner surface of the pipe member, wherein, in the pipe member made of Nb or the Nb alloy after the diameter reduction, the average crystal grain size is 0.1 to 2 µm, and preferably, the total concentration of oxygen, nitrogen, and carbon is 120 ppm or less.

According to the fabrication method of the present invention, uniform working is achieved and a Nb₃Sn superconducting wire exhibiting good superconducting properties can be fabricated. In such a superconducting wire, the critical current density Jc of a non-copper portion is 130 A/mm² or more when measured at an external magnetic field of 21 T and a temperature of 4.2 K.

In accordance with the present invention, in the fabrication of a superconducting wire, by using a pipe member in which the average crystal grain size and the total concentration of oxygen, nitrogen, and carbon are set in appropriate ranges, it is possible to prevent disconnection and Sn leakage from occurring during the process to achieve uniform working, and thus a Nb₃Sn superconducting wire exhibiting good superconducting properties can be fabricated.

### BRIEF DESCRIPTION OF THE DRAWINGS

Fig. 1 is a schematic cross-sectional view showing a state in which a Nb₃Sn superconducting wire is fabricated by a powder process;
Fig. 2 is a micrograph showing a cross-section of sample J, which is given as a substitute for a drawing; and
Fig. 3 is a micrograph showing a cross-section of sample K, which is given as a substitute for a drawing.

### DESCRIPTION OF THE PREFERRED EMBODIMENTS

The present inventors have investigated the cause of occurrence of nonuniform change in shape in the pipe member during extrusion and wire drawing in a tube process or a powder process. As a result, it has been found that in the pipe member made of Nb or a Nb alloy, a material having a relatively large Nb crystal grain size is generally used since good workability is structurally required, and this causes the nonuniform change in shape. That is, in the pipe member, in order to ensure good workability, a material having an average crystal grain size of 100 µm or more before working is used. However, if the workability is good, a nonuniform change in shape easily occurs.

Accordingly, the present inventors have conducted an investigation on the basis of an idea that the average crystal grain size in the pipe member must be relatively decreased in order to prevent the nonuniform change in shape. As a result, it has been found that the nonuniform change in shape does not occur if the average crystal grain size before working is set at about 4 to 80 µm and/or if the average crystal grain size after working is set at about 0.1 to 2 µm. If the average crystal grain size is less than 4 µm, work hardening increases, and breakage of the pipe member occurs frequently. As a result, in the heat treatment to generate Nb₃Sn, Sn diffuses into the Cu matrix through the pipe breakage, thus decreasing superconducting properties. If the average crystal grain size exceeds 80 µm, a nonuniform change in shape occurs in the pipe member, which increases the probability of occurrence of portions with a significantly small thickness in the pipe member as the working proceeds. As a result, in the heat treatment to generate Nb₃Sn, Sn penetrates the pipe and diffuses into the Cu matrix, thus decreasing superconducting properties.

However, by only decreasing the Nb crystal grain size, in some cases, an increase in the strength of the member during working (work hardening) may become excessively high, and there may be a difficulty even in forming into the pipe member and performing extrusion and wire drawing. A further investigation has been conducted to prevent such inconveniences, and as a result, it has been found that when the elements, such as oxygen, nitrogen, and carbon, in the pipe member are suppressed, work hardening is suppressed and stable working is achieved. In order to obtain such effects, it is necessary to set the total concentration of oxygen, nitrogen, and carbon in the pipe member at 120 ppm or less, and more preferably 20 to 100 ppm. In the pipe members which have been so far used, the amount of oxygen, nitrogen, and carbon is not taken into consideration at all, and usually, pipe members having a total concentration of 200 to 300 ppm are used.

The average crystal grain size in the pipe member can be controlled by adjustment by working, such as forging and rolling, and annealing. Furthermore, the amount of oxygen, nitrogen, and carbon in the pipe member can be decreased by increasing the purity of the master alloy, for example, by increasing the vacuum level during the melting of the alloy, or repeated melting in a high vacuum.

The core material used in the present invention contains at least Sn, and a specific example thereof include a core material containing Sn and at least one metal selected from the group consisting of Ti, Zr, Hf, V, Ta, and Cu. As the form of the core material, any of alloy powder, intermetallic compound powder, mixed powder, or an alloy member containing these components can be employed. Among the components contained in the core material, Sn forms a Nb₃Sn layer by reaction with Nb or a Nb-based alloy disposed therearound. Furthermore, the components, such as Ti, Zr, Hf, V, and Ta, are effective in accelerating the formation of the Nb₃Sn layer and improving the Jc value at 21 T or more by solid solution in the Nb₃Sn layer. Furthermore, Cu has an effect of decreasing the heat treatment temperature (for example, to about 600°C to 800°C). Additionally, in the tube process, in order to incorporate Cu into the core material, a thin layer of Cu may be disposed inside a sheath.

The mixing ratio between Sn and the other components in the core material can be appropriately set from the standpoint of superconducting properties. In view of the reactivity of Sn, preferably Sn is mixed or incorporated in an amount of 20% by mass or more.

In the Nb₃Sn superconducting wire fabricated so as to satisfy the conditions described above, as will be shown in examples described below, excellent superconducting properties are exhibited, for example, the critical current density Jc of the non-copper portion is 130 A/mm² or more when measured at an external magnetic field of 21 T and a temperature of 4.2 K.

The present invention will be described more in details by way of examples. However, it is to be understood that the examples described below do not limit the present invention, and changes in design according to the purposes described above and below are included in the technical scope of the present invention.

### EXAMPLE 1

Ta powder and Sn powder at a size of 350 mesh (with a particle size of 40 µm or less) were mixed so as to satisfy an atomic ratio of Ta:Sn = 6:5, and 2% by mass of Cu powder was added thereto, followed by further mixing. The resulting mixture was placed in an aluminum bowl, and heat treatment was performed in a vacuum of 0.01 Pa at 950°C for 10 hours. The heat-treated mixture was pulverized and placed in the aluminum bowl again, and heat treatment was performed in a vacuum of 0.01- Pa at 950°C for 10 hours, followed by pulverization to form Ta-Sn-Cu alloy powder with a particle size of 100 µm or less.

The resulting alloy powder was loaded into pipes made of Nb-7.5% by mass Ta alloys with an outer diameter of 17 mm and an inner diameter of 11 mm, the alloys having different concentrations of oxygen, nitrogen, and carbon gas components or different crystal grain sizes. With respect to all the samples, the hydrogen concentrations were also measured, and the results were 5 ppm or less, which was not influential. Those having a small average crystal grain size (10 µm or less) were obtained by forging, and those having a large average crystal grain size were adjusted by annealing (heat treatment at 800°C to 1,000°C) in a vacuum. The average crystal grain size before working of the pipe and the gas components were measured by the processes described below. The average crystal grain size at the final wire diameter was calculated from the subsequent working ratio.

### [Process for calculating average crystal grain size before working]

Three fields of view were examined with an optical microscope (at a magnification of 10 to 100), and using an intercept method (a method in which the sizes of crystal grains contained in lines orthogonal to each other and having a predetermined length are measured in each field of view and the average is found), the average crystal grain size thereof was calculated.

### [Process for calculating average crystal grain size after working]

Using a high-resolution, field-emission scanning microscope, reflection electron images (at a magnification of 2,000 to 20,000) in three fields of view were examined, and the average crystal grain size was calculated by the intercept method.

### [Process for measuring gas components]

The concentrations of the gas components, such as oxygen, nitrogen, carbon, and hydrogen, were measured using an inert gas fusion analyzer.

Seven Nb alloy pipes filled with the alloy powder were loaded into extrusion billets (outer diameter: 67 mm) with respect to each sample. The extrusion billets were subjected to extrusion and cold wire drawing using dies to fabricate a wire having a final wire diameter of 1.5 mm.

Each wire was subjected to heat treatment in a vacuum at 820°C for 80 hours. With respect to the resulting wires, wire drawing results and the critical current (Ic) in liquid helium (temperature: 4.2 K) in a high magnetic field (external magnetic field: 21 T) were measured. The Ic value was divided by the area of the non-copper portion in the cross-sectional area of the wire to evaluate the critical current density (Jc: A/mm²). Table 1 below shows the results thereof together with the composition of the Nb-Ta alloy pipe and the average crystal grain sizes (before and after working).

**TABLE 1**

| Sample | Composition of Nb-Ta alloy pipe (ppm) | | | | Crystal grain size: before working (µm) | Crystal grain size: after working (µm) | Jc [21T, 4.2K] (A/mm²) | Remarks |
|---|---|---|---|---|---|---|---|---|
| | Oxygen | Nitrogen | Carbon | Total | | | | |
| A | 44 | <10 | 15 | <69 | 27 | 0.6 | 151 | Present invention |
| B | 44 | <10 | 15 | <69 | 4 | 0.1 | 143 | Present Invention |
| C | 44 | <10 | 15 | <69 | 2 | 0.04 | 83 | Sn leakage |
| D | 58 | 24 | 32 | 114 | 140 | 3.1 | 69 | Sn leakage |
| E | 58 | 24 | 32 | 114 | 68 | 1.5 | 132 | Present invention |
| F | 53 | 37 | 41 | 131 | 54 | 1.2 | 71 | Snleakage |
| G | 53 | 37 | 41 | 131 | 9 | 0.2 | 76 | Sn leakage |
| H | 100 | 40 | 42 | 182 | 180 | - | - | Disconnection |
| I | 100 | 40 | 42 | 182 | 65 | 1.6 | 48 | Sn leakage |

As is evident from the results, in all samples other than sample H, it was possible to perform wire drawing until the final wire diameter was achieved. With respect to sample H, it is considered that because of the high concentration of gas components, significant work hardening, and the large crystal grain size before working, the nonuniform change in shape during the working increased significantly, resulting in disconnection. With respect to the other samples (samples A to G and I), although it was possible to perform wire drawing until the final wire diameter was achieved, the superconducting properties (critical current density) varied depending on the conditions.

With respect to samples A, B, and E, the Jc value exceeded 130 A/mm² even at an external magnetic field of 21 T. However, with respect to samples C, D, G, and I, the Jc value was only about half of the above value. The reflection electron images of the cross-sections of the samples C, D, G, and I were subsequently examined by an electron microscope, and it was confirmed that breakage occurred in the Nb-Ta pipe, Sn leaked into the Cu section, and Nb₃Sn was not generated efficiently in all of the samples.

### EXAMPLE 2

Into each of pipes made of Nb-7.5% by mass Ta alloys having different concentrations of oxygen, nitrogen, and carbon gas components and different average crystal grain sizes, each pipe having an outer diameter of 55 mm and an inner diameter of 30 mm, a Cu pipe having an outer diameter of 30 mm and an inner diameter of 26 mm was inserted, and a Sn rod having an outer diameter of 26 mm was further inserted thereinto. The Nb-Ta alloy pipe was covered with a Cu pipe having an outer diameter of 67 mm to form an extrusion billet, and the billet was extruded at room temperature to achieve an outer diameter of 28 mm. Subsequently, the outer diameter was reduced to 0.3 mm by wire drawing using dies.

Each wire was subjected to heat treatment in a vacuum at 700°C for 80 hours. With respect to the resulting wires, wire drawing results and the critical current (Ic) in liquid helium (temperature: 4.2 K) in a high magnetic field (external magnetic field: 21 T) were measured. The Ic value was divided by the area of the non-copper portion in the cross-sectional area of the wire to evaluate the critical current density (Jc: A/mm²). Table 2 below shows the results thereof together with the composition of the Nb-Ta alloy pipe and the average crystal grain sizes (before and after working).

**TABLE 2**

| Sample | Composition of Nb-Ta alloy pipe (ppm) | | | | Crystal grain size: before working (µm) | Crystal grain size: after working (µm) | Jc [21 T, 4.2 K] (A/mm²) | Remarks |
|---|---|---|---|---|---|---|---|---|
| | Oxygen | Nitrogen | Carbon | Total | | | | |
| J | 44 | <10 | 15 | <69 | 27 | 0.3 | 162 | Present invention |
| K | 100 | 40 | 42 | 182 | 180 | - | - | Disconnection |

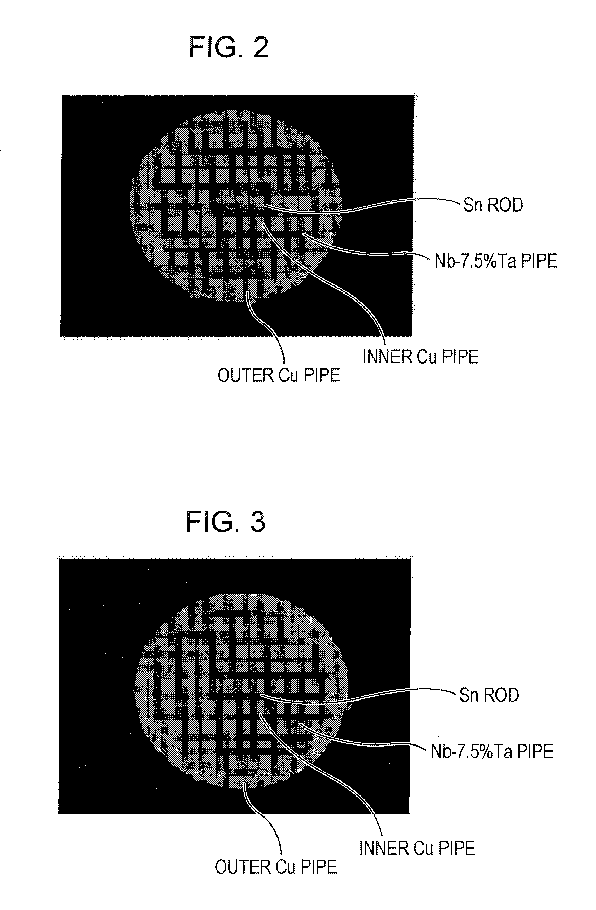

As is evident from the results, in sample J, it was possible to perform wire drawing until the final wire diameter was achieved and the Jc value was high. However, in sample J, disconnection occurred during the working and the final wire diameter was not achieved. Figs. 2 and 3 are optical micrographs respectively showing cross-sections of samples J and K immediately after extrusion.

As is evident from Figs. 2 and 3, in sample J (Fig. 2), wire drawing was performed soundly, while in sample K (Fig. 3), the Nb-Ta alloy pipe was significantly nonuniformly reduced. With respect to sample K, it is considered that because of the high concentration of gas components, significant work hardening, and the large crystal grain size before working, the nonuniform change in shape during the working increased significantly, resulting in disconnection.

A method for fabricating a Nb₃Sn superconducting wire includes the steps of loading or inserting a core material containing at least Sn into a pipe member made of Nb or a Nb alloy, inserting the pipe member into a Cu billet to form a composite member, subjecting the composite member to diameter reduction, and then heat-treating the composite member to form a Nb₃Sn superconducting layer from the inner surface of the pipe member, wherein, in the pipe member made of Nb or the Nb alloy after the diameter reduction, the average crystal grain size is 0.1 to 2 µm, and preferably, the total concentration of oxygen, nitrogen, and carbon is 120 ppm or less.

## Claims

1. A precursor for fabricating a Nb₃Sn superconducting wire comprising a composite member including:
a pipe member made of Nb or an Nb alloy;
a core material containing at least Sn loaded or inserted into the pipe member; and
a Cu billet disposed around the pipe member,
wherein the pipe member made of Nb or the Nb alloy has an average crystal grain size of 4 to 80 µm and a total concentration of oxygen, nitrogen, and carbon of 120 ppm or less.

2. A method for fabricating a Nb₃Sn superconducting wire comprising the steps of:
loading or inserting a core material containing at least Sn into a pipe member made of Nb or a Nb alloy;
inserting the pipe member into a Cu billet to form a composite member;
subjecting the composite member to diameter reduction; and
subsequently heat-treating the composite member to form a Nb₃Sn superconducting layer from an inner surface of the pipe member,
wherein, in the pipe member made of Nb or the Nb alloy after the diameter reduction, the average crystal grain size is 0.1 to 2 µm.

3. A Nb₃Sn superconducting wire fabricated by the method according to Claim 2, wherein the critical current density Jc of a non-copper portion is 130 A/mm² or more when measured at an external magnetic field of 21 T and a temperature of 4.2 K.
